## Europäisches Patentamt

## European Patent Office

## Office européen des brevets

(19)

(11) Veröffentlichungsnummer: **0 244 496 B1**

(12) **EUROPÄISCHE PATENTSCHRIFT**

(45) Veröffentlichungstag der Patentschrift:
16.01.91 Patentblatt 91/03

(51) Int. Cl.⁵: **G03F 1/16**

(21) Anmeldenummer: **86106188.5**

(22) Anmeldetag: **06.05.86**

(54) **Maske für die Ionen-, Elektronen- oder Röntgenstrahllithographie und Verfahren zur ihrer Herstellung.**

(43) Veröffentlichungstag der Anmeldung:
11.11.87 Patentblatt 87/46

(45) Bekanntmachung des Hinweises auf die
Patenterteilung:
16.01.91 Patentblatt 91/03

(84) Benannte Vertragsstaaten:
DE FR GB

(56) Entgegenhaltungen:
EP-A- 0 167 948
IBM TECHNICAL DISCLOSURE BULLETIN,
Band 26, Nr. 7A, Dezember 1983, Seite 3263,
New York, US; J. GRESCHNER et al.: "Shadow
projection mask for X-ray, ion and electron
beam lithography"

(73) Patentinhaber: IBM DEUTSCHLAND GMBH
Pascalstrasse 100
D-7000 Stuttgart 80 (DE)
DE
Patentinhaber: International Business
Machines Corporation
Old Orchard Road
Armonk, N.Y. 10504 (US)
FR GB

(72) Erfinder: **Asch, Karl**
**Siedlerstrasse 7**
**D-7033 Herrenberg-Gültstein (DE)**
Erfinder: **Kempf, Jürgen, Dr.**
**Friesenweg 9**
**D-7036 Schönaich (DE)**
Erfinder: **Keyser, Joachim**
**Am Killberg 9**
**D-7277 Wildberg - 4 (DE)**
Erfinder: **Zapka, Werner, Dr.**
**Ritterstrasse 29**
**D-7031 Gärtringen-Rohrau (DE)**

(74) Vertreter: **Mönig, Anton, Dipl.-Ing.**
**IBM Deutschland GmbH Patentwesen und**
**Urheberrecht Schönaicher Strasse 220**
**D-7030 Böblingen (DE)**

## Beschreibung

Die Erfindung betrifft eine Maske für die Ionen-, Elektronen-oder Röntgenstrahllithographie, die ein ebenes Halbleiterplättchen aufweist, dessen eine Oberfläche mindestens bereichsweise bis in eine Tiefe von 2-3 µm anders dotiert ist als das übrige Halbleiterplättchen (1) und das von der anderen Oberfläche aus selektiv bis zu der anders dotierten Schicht unter Bildung einer Membran (3) weggeätzt ist, und ein das Maskenmuster definierendes Lochmuster (4) entweder in die Membran (3) oder in eine auf der Membran aufliegende Schicht (5) hineingeätzt ist und ein Verfahren zum Herstellen einer solchen Maske, bei dem ein Halbleiterplättchen von der einen Oberfläche aus 2-3 µm tief anders als das übrige Halbleiterplättchen dotiert wird und von der anderen Oberfläche aus selektiv bis zu der anders dotierten Schicht unter Erzeugung der Membran (3) weggeätzt wird, und bei dem das das Maskenmuster definierende Lochmuster (4) in die Membran bzw. dort, wo die Membran entstehen soll, in das Halbleiterplättchen oder in eine auf der Membran aufgebrachte Schicht (5) hineingeätzt wird.

Solche Masken werden verwendet, um mittels Projektionsbestrahlung mit Ionen-, Elektronen- oder Röntgenstrahlen das Maskenmuster - üblicherweise um den Faktor 5 verkleinert - in eine Photolackschicht zu übertragen.

Eine Maske, bei welcher das Maskenmuster auf der Membran aufliegt, ist beispielsweise in dem US-Patent 3 742 230 und eine Maske, bei welcher das Maskenmuster durch ein in der Membran erzeugten Maskenmuster definiert ist in dem Europäischen Patent 0 019 779 beschrieben. Auch die Verfahren zur Herstellung dieser Masken sind aus den genannten Patentschriften bekannt.

Bei der aus dem genannten Europäischen Patent bekannten Maske ist die Membran bordotiert. Die Bordotierung bewirkt eine hohe Zugspannung in der dünn geätzten Schicht, was zur Folge hat, daß das Halbleiterplättchen verbogen ist. Eine solche Verbiegung kann, wenn sehr dicht gepackte, miniminiaturisierte Maskenmuster mit der Maske übertragen werden sollen, nicht toleriert werden. In dem Artikel "Shadow Projection Mask for X-Ray, Ion and Electron Beam Lithography" von J. Greschner u.a., veröffentlicht im IBM Technical Disclosure Bulletin, Band 26, Nr. 7a, Dezember 1983, Seite 3 263 wird eine Lösung dieses Problems beschrieben, welche darin besteht, daß die 2-3 µm dicke Bordotierung nur in den Bereichen des Halbleiterplättchens erzeugt wird, welche anschließend dünn geätzt werden, bzw. in denen das Maskenmuster erzeugt wird. Unabhängig davon, ob die dotierte Schicht sich ganzflächig über die eine Oberfläche des Halbleiterplättchens oder nur über Bereiche derselben erstreckt, sind die dünn geätzten Bereiche wegen der durch das Bor verursachten Zugspannung gespannt und - wenn man eine nennenswerte Verbiegung des Halbleiterplättchens ausschließt -eben. Erst bei einer hinreichenden, von der Dotierung abhängigen Temperatur findet eine Ausbeulung der Membran statt. H. Bohlen u.a. haben bei dem "Symposium on the Eighth International Conference on Electron and Ion Beam Science and Technology" (1978) vorgetragen, daß bei einer Oberflächenkonzentration des Bors von $10^{19}$ Atomen/$cm^{-3}$ eine Ausbeulung der dünn geätzten Schicht bei etwa 120°C stattfindet.

P. Nemitz u.a. haben (siehe Proceedings of the 1984 International Symposium on Electron, Ion and Photon Beams, Territown, N.J., USA (1984), Seite 136) von einer Maskenverzerrung berichtet, die mit dem Verfahren zusammenhängt, welches bei der Herstellung der Masken angewandt wird. Bei diesem Verfahren wird das Maskenmuster in oder auf der dotierten Schicht erzeugt, bevor das Dünnätzen erfolgt. Da die dotierte Schicht in diesem Herstellungstadium über ihre ganze Ausdehnung mit dem übrigen Substrat zusammenhängt, was eine Auswirkung der Zugspannung verhindert, ist das übertragene Muster ein getreues Abbild des gewünschten Musters. Wird anschließend selektiv dünn geätzt, dann verursacht die Zugspannung in der nur noch am Rand festgehaltenen Membran eine Verzerrung des Musters in der Maskenebene. Diese sogenannte "Kaltverzerrung" ist im Mittelpunkt und am Rand der Membran gleich Null und in einer Zone, welche näher beim Mittelpunkt als beim Rand liegt, maximal. Die "Kaltverzerrung" läßt sich durch eine entsprechende Dotierung mit einem Druckspannung in Silizium erzeugenden Material kompensieren. Die Menge an Dotierungsmaterial, welches zur Kompensation der "Kaltverzerrung" erforderlich ist, ist temperaturabhängig. Will man z.B. daß die Membran bei einer Temperatur von 40°C spannungsfrei und damit unverzerrt ist, dann ist eine geringere Menge erforderlich, als wenn die Membran bei 20°C spannungsfrei sein soll. Ein verzerrungsfreies und gleichzeitig ebenes Muster wird dadurch jedoch nur erreicht, wenn es gelingt, die festgelegte Temperatur einheitlich über die ganze Membran aufrecht zu erhalten. Es ist aber bei der bestimmungsgemäßen Verwendung der Masken, nämlich bei der Bestrahlung mit Ionen-, Elektronen- und Röntgenstrahlen nicht möglich, eine einheitliche Temperatur der dünn geätzten Schicht zu erreichen, vielmehr wird dabei die Membran in ihrem Mittelpunkt immer heißer sein als am Rand. Dabei ist die - nicht kompensierbare -Verzerrung umso größer je größer die Temperaturdifferenz zwischen Rand und Mitte der Membran ist.

Bekannt ist es, beim Elektronenstrahlbelichten den maximalen Strahlstrom so gering zu halten ($I \leq 10$ µA), daß die Temperaturerhöhungen $\Delta T$ nicht mehr als etwa 10° betragen, und bei der Röntgenstrahllithographie die Maskenaufheizung während der Belichtung dadurch zu verhindern, daß eine Heliumatmosphäre in der Umgebung für die Abführung der in der Maske erzeugten Wärme sorgt. Diese Heliumatmosphäre hat nun einige Nachteile. So beschränkt sie einerseits aufgrund der Absorption für Röntgenstrahlen das für die Lithographie verwendbare Spektrum. Andererseits erfordert sie einen hohen (sicherheits-)technischen Aufwand, da mittels mehrerer Druckstufen der Bereich der Heliumatmosphäre sukzessive an das Hochvakuum am Ort der Röntgenstrahlquelle angeglichen werden muß. Während des Betriebes müssen extrem schnelle Ventile dafür sorgen, daß im Falle des Berstens eines Fensters auf jeden Fall ein Gaseinbruch am Ort der Quelle vermieden wird.

Es ist die Aufgabe der Erfindung, eine Maske für die Ionen-, Elektronen- oder Röntgenstrahllithographie, welche ein bereichsweise dünn geätztes Halbleiterplättchen aufweist, wobei auf oder in den dünn geätzten Bereichen das Maskenmuster ausgebildet ist, welche es erlaubt, ein gewünschtes Muster verzerrungsfrei zu übertragen, ohne daß es erforderlich ist, mit sehr kleinen Strahlströmen zu arbeiten oder eine sehr aufwendige Kühlvorrichtung vorzusehen, und ein Verfahren zur Herstellung der Maske anzugeben.

Diese Aufgabe wird mit einer Maske der eingangs genannten Art mit den Merkmalen des kennzeichnenden Teils des Patentanspruchs 1 und mit einem Verfahren der eingangs genannten Art mit den Merkmalen des kennzeichnenden Teils des Patentanspruchs 8 gelöst.

Unter der Zuspannung erzeugenden Dotierung ist nicht die Gesamtheit der Atome zu verstehen, die aufgrund ihres Atomdurchmessers in der Membran Zugspannung zu erzeugen vermögen, sondern nur diejenigen dieser Atome, deren Wirkung nicht durch Atome, die Druckspannung erzeugen, kompensiert ist.

Wird die erfindungsgemäße Maske, deren Zugspannung erzeugende Dotierung auf einen festgelegten Strahlstrom abgestimmt ist, diesem Strahlstrom ausgesetzt, so liegt dasselbe unverzerrte Maskenmuster wie vor dem Dünnätzen des Maskensubstrats vor. Dies ist auch dann der Fall, wenn die dabei in der Membran auftretenden Temperaturunterschiede beachtlich sind. Die erfindungsgemäße Maske ist also mit anderen Worten in der Lage, mit einem hohen Durchsatz ein gewünschtes Maskenmuster mustergetreu beispielsweise in Photolackschichten zu übertragen, wobei man auf aufwendige Kühlvorrichtungen verzichten kann.

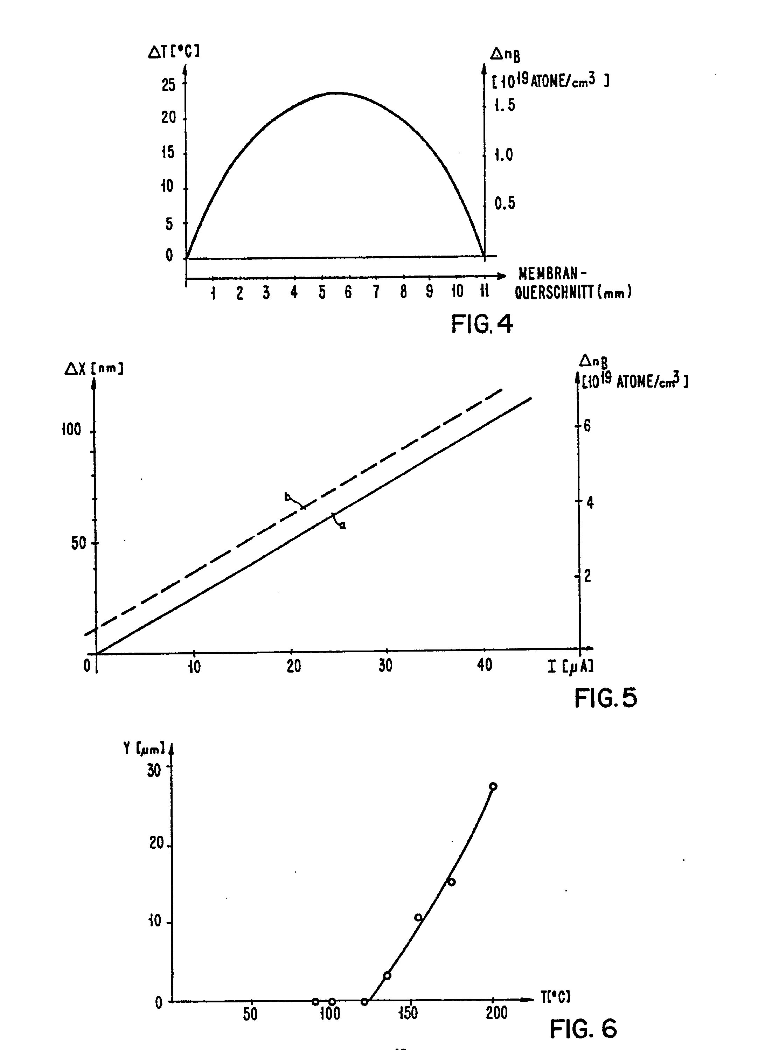

Der mit der Maske erzielte Effekt kann als Pseudokühlung bezeichnet werden, weil die Zugspannung erzeugende Dotierung in derselben Weise eine Druckspannung in der Membran abzubauen vermag wie eine Abkühlung. Es besteht dabei ein nahezu linearer Zusammenhang sowohl zwischen der Erniedrigung der Temperatur und der ansteigenden Zugspannung als auch - wie festgestellt wurde insbesondere bei einer Dotierung im Bereich zwischen $10^{19}$ und $10^{20}$ Boratomen/$cm^3$ - zwischen der zunehmenden Dotierung und der zunehmenden Zugspannung. Ist das durch die Dicke und die Fläche der dünnen Schicht und die Fläche der das Maskenmuster definierenden Löcher bzw. des aus einem gut leitenden Metall bestehenden Maskenmusters bestimmte Temperaturprofil bei dem festgelegten Strahlstrom bekannt, kennt man auch bis auf einen Faktor das zur Entzerrung erforderliche Dotierungsprofil. Der Faktor läßt sich durch einfache, im Rahmen des fachmännischen Handelns liegenden Versuche ermitteln, wobei das Kriterium für die richtige Dotierung die mechanische Spannungsfreiheit im bestrahlten Zustand ist. Das Temperaturprofil bei Bestrahlung der Membran bzw. das Profil der Dotierung, welche erforderlich ist, um die mechanische Spannungsfreiheit sicherzustellen, zeigt die Fig. 4 für einen bestimmten Strahlstrom.

Es ist vorteilhaft, die Zugspannung erzeugende Dotierung etwas geringer zu machen als erforderlich ist, um die Spannung auf Null zu bringen. Es muß dann zwar eine geringe Verzerrung in Kauf genommen werden, man vermeidet aber die Gefahr, welche bei einer genauen Anpassung des Dotierungsprofils an das Temperaturprofil gegeben ist, daß nämlich bei einer nur geringfügigen weiteren Erhöhung der Temperatur eine Ausbeulung der Membran stattfindet.

Bei einer bevorzugten Ausführungsform der erfindungsgemäßen Maske beinhaltet die Membran

1. eine Dotierung, welche sicherstellt, daß beim Dünnätzen des Halbleiterplättchens eine 2-3 μm dicke Membran stehen bleibt (Dotierung zum Ätzstop). (Diese Dotierung kann, wenn das Halbleiterplättchen eine p- oder eine n-Dotierung aufweist, eine p⁺-Dotierung mit Bor, oder, wenn das Halbleiterplättchen n⁺ dotiert ist, eine n-Dotierung mit Phosphor sein.)

2. eine Dotierung, welche durch die erste Dotierung bei Raumtemperatur verursachte mechanische Spannungen auf Null bringt, und

3. eine Zugspannung erzeugende, auf die Erwärmung beim Bestrahlen abgestimmte Dotierung beispielsweise aus Bor.

Es wird bei dieser Ausführungsform davon ausgegangen, daß es gelingt, während des Bestrahlens den Rand der Membran auf Zimmertemperatur zu halten. Ist dies nicht möglich, so muß der unter 3. aufgeführten Dotierung noch eine der zusätzlichen Erwärmung entsprechende gleichmäßige Dotierung mit dem Zugspannung erzeugenden Material überlagert werden.

Die erfindungsgemäße Dotierung der Membran kann entweder mittels Ausdiffusion bereits eingebauter Atome, mittels Diffusion oder mittels Ionenimplantation erfolgen.

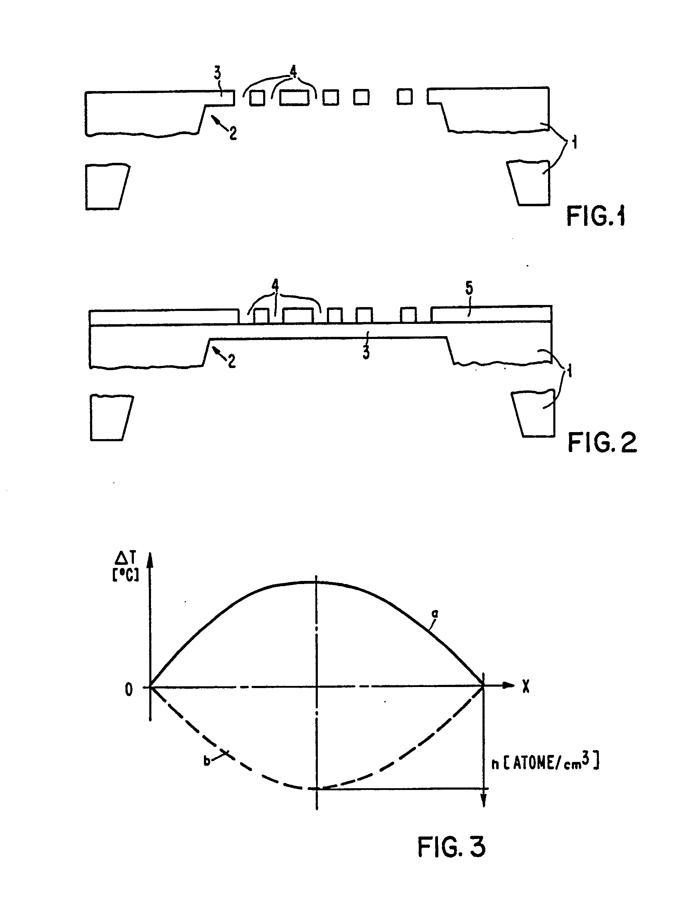

Soll die erfindungsgemäße Dotierung mittels Diffusion erfolgen, kann man so vorgehen, daß man, nachdem die Membran so behandelt worden ist, daß sie bei Raumtemperatur spannungsfrei ist, durch Bestrahlung in der Membran ein uneinheitliches Temperaturprofil (vergleichbar der Kurve a in der Fig. 2) erzeugt, wobei die Temperatur am Rand der Membran gerade unter dem Wert liegt, bei der das vorgesehene Dotierungsmaterial eine beachtliche Diffusionskonstante in dem Halbleitermaterial hat, und dann diffundiert, wobei wegen der Temperaturabhängigkeit der Diffusionskonstanten die Dotierung in der Mitte der Membran stärker sein wird als am Rand. Apparativ einfacher ist die Dotierung mittels Ionenimplantation, wobei der Ionenstrahl mit den Ionen aus dem Dotierungsmaterial Zeile für Zeile über die Membran geführt wird, bis schließlich jeder Punkt der Membran bestrahlt worden ist und dabei ortsabhängig je nach dem gewünschten Dotierungsprofil die Ionenintensität bzw. die Geschwindigkeit, mit der der Strahl geführt wird, computergesteuert variiert wird.

In dem relativ häufigen Fall einer Ätzstopdotierung mit Bor, d.h. mit einem Zugspannung erzeugenden Material, kann die erfindungsgemäße Dotierung auch so erfolgen, daß entweder mit einem Druckspannung erzeugenden Material entsprechend einem zu dem in der Kurve b der Fig. 3 gezeigten Profil inversen Profil dotiert wird oder in dem die dünn geätzte Schicht mit einer Schicht aus einem für Bor etwas durchlässigen Material mit einer Dickenverteilung, welche dem in der Kurve b der Fig. 3 gezeigten Profil proportional ist, bedeckt wird und dann das Bor durch Erhitzen zum Ausdiffundieren gebracht wird, was aufgrund der unterschiedlich dicken Bedeckung zu einem lokal unterschiedlichen Borverlust führt.

Andere vorteilhafte Ausgestaltungen der erfindungsgemäßen Maske und des erfindungsgemäßen Verfahrens zu ihrer Herstellung sind in den Unteransprüchen angegeben.

Die Erfindung wird anhand von durch Zeichnungen erläuterten Ausführungsbeispielen beschrieben.

Es zeigen :

Fig. 1 und 2 in schematischen Darstellungen Querschnitte durch zwei Ausbildungsformen der erfindungsgemäßen Maske,

Fig. 3 in einem Diagramm aufgetragen über der Membran in den Fig. 1 und 2 entlang den Querschnitten a) die sich bei Bestrahlung einstellenden Temperaturdifferenzen und b) die Dotierung gemäß der Erfindung, durch welche erreicht wird, daß trotz der Bestrahlung und der dadurch entsprechend a) sich einstellenden Temperaturdifferenzen die Membran spannungsfrei ist,

Fig. 4 die in der Fig. 3 gezeigte Kurve b) für eine Membran mit festgelegter Ausgestaltung und einen festgelegten Strahlstrom,

Fig. 5 in einem Diagramm aufgetragen über dem die Maske treffenden Strahlstrom einerseits die maximale Verzerrung (Kurve a), die in der Maskenmembran dabei auftritt, wenn die erfindungsgemäße Dotierung fehlt, und andererseits die Bordotierungsdifferenz zwischen der Mitte und dem Rand der Membran, durch welche die Verzerrung beim entsprechenden Strahlstrom entweder vollständig (ebenfalls Kurve a) oder bis auf einen definierten Rest (gestrichelte Kurve b) verhindert wird,

Fig. 6 in einem Diagramm aufgetragen über der Temperatur die Ausbeulung y einer eine Ätzstopdotierung aufweisenden Membran in einer Maske gemäß dem Stand der Technik und

Fig. 7a-7c in Diagrammen, die B- und - gegebenenfalls -Ge-Dotierungsprofile aufgetragen über Querschnitten durch die Membran bei drei Ausführungsformen der erfindungsgemäßen Maske.

Im folgenden soll die erfindungsgemäße Maske anhand der Fig. 1 und 2 besprochen werden. In den geometrischen Abmessungen ist die erfindungsgemäße Maske mit den bekannten Masken praktisch identisch.

In der Fig. 1 ist in schematischer Querschnittsdarstellung ein Ausschnitt aus einem Plättchen 1 gezeigt. Bei den folgenden Ausführungen wird dabei ausgegangen, daß das Plättchen 1 aus Silizium besteht. Es sei aber klargestellt, daß das Plättchen 1 auch aus einem anderen Halbleitermaterial bestehen kann. Das Plättchen 1 ist üblicherweise 300-400 µm dick. Von der einen Oberfläche erstreckt sich eine wannenförmige Vertiefung 2 in das Siliziumplättchen 1 hinein. Den Boden der wannenförmigen Vertiefung bildet eine 2-3 µm dicke Membran 3, welche mit der anderen Oberfläche des Plättchens 1 koplanar ist. In die Membran 3 ist ein Muster 4 aus durchgehenden Löchern geätzt, welches das Maskenmuster definiert. Eine Maske mit den geschilderten Merkmalen gehört zum Stand der Technik. Sie wird insbesondere dazu benutzt, um festgelegte Maskenmuster mittels Ionen-, Elektronen- und Röntgenstrahlen in eine Photolackschicht zu übertragen. Die durchgehenden Löcher in der Maske sind jedenfalls bei Verwendung von Ionen- und Elektronenstrahlen erforderlich, da diese Partikel in fester Materie stark absorbiert werden. Da ein Muster durchgehender Löcher keine ringförmigen Löcher aufweisen kann, solche Musterelemente in einer Maske aber üblicherweise enthalten sind, werden zum Übertragen der Muster in die Photolackschicht üblicherweise zwei komplementäre Masken verwendet, deren Lochmuster so ausgebildet sind, daß, wenn die beiden Masken in der richtigen Weise zueinander justiert übereinander projiziert werden, sich das gewünschte Muster ergibt. Die Verteilung der Lochelemente auf den beiden Komplementärmasken erfolgt so, daß die Gesamtlochfläche auf den beiden Masken ungefähr gleich groß ist und daß eine ungefähr gleichmäßige Lochverteilung über die Maskenfläche vorhanden ist. Es hat verschiedene Vorteile, die zu den beiden Komplementärmasken gehörenden Lochmuster auf einer Membran 3 unterzubringen.

Die in der Fig. 2 gezeigte Maske unterscheidet sich nur dadurch von der in Fig. 1 gezeigten, daß sich das Lochmuster 4 in einer auf dem Plättchen 1 aufgebrachten, bevorzugt aus Gold bestehenden Schicht 5 befindet und die Membran 3 eine geschlossene Schicht bildet. Die in der Fig. 2 gezeigte Maske wird verwendet zum Übertragen von Maskenmuster mittels Röntgenstrahlen. Da Röntgenstrahlen wesentlich weniger als Elektronen- und Ionenstrahlen in fester Materie absorbiert werden, ist es nicht erforderlich, eine Maske mit durchgehenden Löchern vorzusehen. Bei einer Maske, wie sie die Fig. 2 wiedergibt, tritt das obengenannte Problem mit ringförmigen transparenten Maskenbereichen nicht auf, infolgedessen kommt man beim Übertragen des Musters mit einer Maske aus.

Die erfindungsgemäße Maske unterscheidet sich von den Masken gemäß dem Stand der Technik durch eine definierte Dotierung der Membran 3. Die Masken müssen unter den Bedingungen der Bestrahlung eine mustergetreue Übertragung des gewünschten Maskenmusters gewährleisten. Mit der zunehmenden Mikrominiaturisierung und der zunehmenden Verdichtung der Schaltungselemente in integrierten Schaltungen werden die Anforderungen an die Mustertreue der Übertragung immer höher, d.h. die zulässigen Toleranzen werden immer kleiner. Die Masken gemäß dem Stand der Technik zeigen unter den Bedingungen der Bestrahlung eine Ausbiegung der Membran 3 aus der Maskenebene oder eine Verzerrung des Maskenmusters in der Maskenebene. Verzerrung des Maskenmusters bedeutet in diesem Zusammenhang eine Verschiebung zumindest eines Teils der Maskenelemente aus ihrer festgelegten Position und die Veränderung ihrer festgelegten Form. Die Ausbiegung, die in keinem Fall tolerierbar ist, kann durch eine homogene Dotierung der Membran 3 mit einem Material, welches, wie z.B. Bor, im Silizium Zugspannung erzeugt, verhindert oder rückgängig gemacht werden. Bei den üblichsten Masken gemäß dem Stand der Technik ist eine solche Bordotierung mindestens in der Membran 3 aus herstellungstechnischen Gründen ohnehin vorhanden. Eine homogene Dotierung der Membran 3 kann aber eine Verzerrung des Maskenmusters unter den Bedingungen der Bestrahlung in keinem Fall verhindern. Dies wäre nur dann möglich, wenn die Membran 3 beim Bestrahlen eine einheitliche Temperatur hätte. Dies ist aber nicht der Fall. Vielmehr hat die Membran 3 beim Bestrahlen in ihrer Mitte ein Temperaturmaximum und an ihrem Rand ein Temperaturminimum. Die Temperaturdifferenz innerhalb der Maskenmembran ist umso größer je größer der angewandte Strahlstrom ist. Mit der zunehmenden Mikrominiaturisierung werden die tolerierbaren Verzerrungen der Maskenmuster immer kleiner. Dem kann bisher nur - wenn man von den umständlichen und äußerst aufwendigen Maskenkühlungen absieht - dadurch Rechnung getragen werden, daß man den Strahlstrom stark reduziert, was das unerwünschte Ergebnis eines sehr kleinen Durchsatzes hat. Die Fig. 3 zeigt schematisch in einem Diagramm (siehe Kurve a) die Temperaturverteilung, welche sich entlang der in den Fig. 1 und 2 gezeigten Querschnitten bei Bestrahlung einstellt. Der in der Membran bei Bestrahlung lokal sich einstellenden Temperaturdifferenz ist eine entsprechende Druckspannung proportional. Es ist nun gefunden worden, daß diese Druckspannung durch eine entsprechende Dotierung der Membran 3 mit einem Element, welches einen kleineren kovalenten Atomradius hat als Silizium (zu diesen Elementen gehören außer Bor z.B. Phosphor, Kohlenstoff) vollständig kompensiert werden kann. Bei der erfindungsgemäßen Maske ist die Membran 3 in festgelegter, auf einen bestimmten Strahlstrom und damit auf ein festgelegtes Temperaturprofil abgestimmter Weise dotiert. Das dabei in der in den Fig. 1 und 2 gezeigten Membranen erzeugte Dotierungsprofil zeigt in schematischer Darstellung die näherungsweise einer Parabelfunktion genügende Kurve b in der Fig. 3. Zur Klarstellung sei hier angemerkt, daß das in der Fig. 3 gezeigte Dotierungsprofil nicht die gesamte möglicherweise in der Membran 3 vorhandene Menge an Zugspannung erzeugende Material erfaßt, sondern nur das nicht durch eine Gegendotierung kompensierte, Zugspannung erzeugende Material. Im folgenden soll an einem speziellen Beispiel die erfindungsgemäße Maske in der Ausgestaltung, welche die Fig. 1 zeigt, noch genauer anhand des in der Fig. 4 gezeigten Dotierungsprofils erläutert werden.

Das Halbleiterplättchen besteht aus Silizium und die Membranfläche ist $11 \times 11$ mm$^2$ groß und 2 μm dick. Die Löcher sind in der Membran gleichmäßig verteilt und ihre Gesamtfläche beträgt ungefähr 40% der Membranfläche. Während der Herstellung der Maske war die Membran bereits mit Bor gleichmäßig dotiert worden. Diese Bordotierung war in einem späteren Verfahrensschritt durch eine einheitliche Germaniumdotierung soweit kompensiert worden, daß die Membran bei Zimmertemperatur spannungsfrei war. Die Membran ist entsprechend dem in der Fig. 4 gezeigten Profil zusätzlich mit Bor dotiert. Dem Diagramm in der Fig. 4 ist zu entnehmen, daß die maximale - zusätzliche - Borkonzentration bei $1,66 \times 10^{19}$ Atomen/cm$^3$ liegt. Die Maske wurde einem Strahlstrom von 10 μA ausgesetzt. Unter diesen Bedingungen betrug die Temperaturdifferenz zwischen der Mitte und dem Rand der Membran 23,5°C, wobei der Rand eine Temperatur von ungefähr 27°C hatte. Die Messung der mechanischen Spannung in der Membran gemäß der weiter unten im Zusammenhang mit der Maskenherstellung beschriebenen Methode ergaben, daß die Maske unter diesen Bestrahlungsbedingungen spannungsfrei war.

Für Masken, welche in den geometrischen Abmessungen mit der in dem Beispiel beschriebenen Maske übereinstimmen, ist der Zusammenhang zwischen Strahlstrom und der erforderlichen, d.h. Spannungsfreiheit gewährleistenden Bordotierungsdifferenz zwischen Membranmitte und Membranrand in der Fig. 5 dargestellt. Dabei ist das zugehörige Dotierungsprofil jeweils dem in der Fig. 4 gezeigten geometrisch ähnlich. In der Fig. 5 ist zusätzlich die maximale thermische Verzerrung aufgetragen, welche sich einstellen würde, wenn die zusätzliche uneinheitliche Dotierung nicht vorhanden wäre. Parallel zu der ausgezogenen Linie ist in der Fig. 5 noch eine gestrichelte Linie gezogen. Wird bei einem festgelegten Strahlstrom eine maximale Dotierungsdifferenz erzeugt, welche der gestrichelten Linie entspricht, so bleibt in der Membran eine Restverzerrung von maximal 10 nm unter den Strahlungsbedingungen zurück. Dies ist die Verzerrung, die beim heutigen Stand der Mikrominiaturisierung gerade noch tolerierbar ist. Es ist sinnvoll, eine Maske etwas höher zu dotieren, als dem anzuwendenden Strahlstrom entspricht, weil, wenn die Dotierung zu genau auf den Strahlstrom und damit auf die sich einstellende Temperaturdifferenz eingestellt wird, die Gefahr besteht, daß bei einer geringfügigen Überschreitung dieser Temperatur eine Ausbiegung der Membran aus der Maskenfläche eintreten kann. Dies muß aber in jedem Fall vermieden werden. Die optimale Dotierungsdifferenz einer für einen bestimmten Strahlstrom bestimmten Maske liegt deshalb zwischen dem auf der durchgezogenen Kurve liegenden und dem auf der gestrichelten Kurve liegenden Wert.

Beim Herstellen der erfindungsgemäßen Maske geht man zunächst wie bei der Herstellung der bekannten Masken vor.

Vorzugsweise wird von einem Halbleiterplättchen ausgegangen. Bei der folgenden Beschreibung besteht dieses Halbleiterplättchen aus einkristallinem Silizium, vorzugsweise mit einer (100)-Orientierung, welches n- oder p-dotiert ist. Es sei aber klargestellt, daß das Plättchen nicht notwendigerweise aus Silizium bestehen soll und auch die angegebene Dotierung ist nicht zwingend, beispielsweise könnte das Silizium auch n$^+$-dotiert sein. Die Dicke des Siliziumplättchens liegt zwischen ungefähr 100 und ungefähr 400 μm. Die eine Oberfläche des Siliziumplättchens wird mit einer p-Leitfähigkeit vermittelnden Verunreinigung hoch dotiert. Es ist günstig, als Verunreinigung Bor zu verwenden. Zur Dotierung werden entweder in bekannter Weise Ionen der Verunreinigung implantiert oder wird die Verunreinigung eindiffundiert. Bei der Dotierung besteht eine p$^+$-dotierte Oberflächenschicht, deren Dicke als der Abstand von der Oberfläche definiert ist, bei dem für den Fall von Bor in Silizium die Dotierungskonzentration $7 \times 10^{19}$ Verunreinigungsatome/cm$^3$ ist. Die hoch dotierte Schicht hat die Eigenschaft, daß es sich in speziellen, bevorzugt wenig dotiertes Silizium ätzenden Lösungen nicht löst. Diese Eigenschaft ist bei dem in einem späteren Verfahrensschritt stattfindenden Dünnätzen des Siliziumplättchens wichtig. (Wird bei der Herstellung der Maske von einem n$^+$-dotierten Siliziumplättchen ausgegangen, so wird für das spätere Dünnätzen mit einer vorzugsweise n$^+$-dotiertes Material ätzenden Lösung eine dünne, n-dotierte Oberflächenschicht durch Dotierung mit einem p-Leitfähigkeit vermittelnden Material erzeugt, welche von dem Ätzmittel für n$^+$-dotiertem Material praktisch nicht angegriffen wird.) Von der hoch dotierten Oberfläche aus wird anschließend das Maskenmuster in das Siliziumplättchen hineingeätzt. Das Ätzen erfolgt vorzugsweise mittels reaktiven Ionenätzens, nachdem in einer auf der Oberfläche aufliegenden Schicht auf photolithographischem Weg eine Ätzmaske, welche das Maskenmuster wiedergibt, erzeugt worden ist. Die Schicht besteht aus Photolack, Siliziumdioxyd, einem Metall oder einer Schichtenkombination solcher Materialien. Einzelheiten der Ätzung sind in dem Europäischen Patent 0 019 779 angegeben. Es wird tiefer geätzt als die hoch dotierte Schicht dick ist. Im Bereich des eingeätzten Musters wird das Siliziumplättchen nunmehr dünn geätzt, indem von der anderen Oberfläche des Siliziumplättchens eine wannenförmige Vertiefung in das Siliziumplättchen hineingeätzt wird. Verwendet zum Ätzen wird bevorzugt eine aus Äthylendiamin, Brenzkatechin, Wasser und u.U. Wasserstoffperoxyd bestehende Lösung. Die Ätzfront kommt dort praktisch zum Stehen, wo die Dotierungskonzentration in der zuvor erzeugten hoch dotierten Schicht $7 \times 10^{19}$ Verunreinigungsatome/cm$^3$ überschreitet, d.h. die stehengebliebene Schicht ist dünner als die Ätztiefe des Lochmusters. Infolgedessen liegt nun innerhalb des - als Rahmen dienenden Siliziumplättchens -eine p$^+$-dotierte dünne Schicht mit einem Muster durchgehender Löcher vor. Einzelheiten des Dünnätzens sind auch in dem Europäischen Patent 0 019 779 beschrieben.

Da Bor - wie oben bereits ausgeführt - in Silizium eine Zugspannung erzeugt, ist das Maskenmuster in der dünnen Schicht, nachdem es nicht mehr durch das nieder dotierte Material des übrigen Siliziumplättchen festgehalten wird, verzerrt. Außerdem verursacht die hoch bordotierte Schicht, sofern sie sich über eine ganze Oberfläche des Siliziumplättchen erstreckt, eine Verbiegung desselben. Im nächsten Verfahrensschritt muß deshalb das Siliziumplättchen spannungsfrei gemacht werden. Dies erfolgt z.B. durch eine homogene Dotierung mit einem Material, welches einen größeren kovalenten Atomdurchmesser als Silizium hat. Solche Materialien sind beispielsweise Arsen oder Germanium.

Die Messung der Spannungsfreiheit beruht auf der folgenden Überlegung. Eine durch Bordotierung mechanisch vorgespannte Siliziummembran in einem ungespannten Siliziumrahmen steht unter starkem internen Zug. Wird nun die Siliziummembran z.B. durch eine Flutbelichtung bei abgedecktem Rahmen bestrahlt, so dehnt sich die Membran aufgrund der Erwärmung aus und vermindert damit die interne mechanische Vorspannung. Bei genügend hoher Erwärmung überkompensiert die thermische Ausdehnung den internen Zug. Die Überkompensation verursacht ein Ausbeulen der Siliziummembran senkrecht zur Maskenfläche. Das in der Fig. 6 gezeigte Diagramm, in welchem die Ausbeulung y der Siliziummembran senkrecht zur Maskenfläche über der Erwärmungstemperatur aufgetragen ist, stellt dieses Verhalten dar. Zur Feststellung der Spannungsfreiheit in der Siliziummembran braucht man also eine Methode, welche es erlaubt, den Knickpunkt der in Fig. 6 gezeigten Kurve zu ermitteln. Es ist nun festgestellt worden, daß man den Knickpunkt der Kurve recht genau feststellen kann, wenn man ein Siliziumplättchen mit einer stark bordotierten Membran unter ein Mikroskop legt, scharf stellt, wobei man die Mitte der Membran beobachtet, und dann langsam erwärmt. In dem Augenblick, in dem das Ausbeulen beginnt, wird das bis dahin scharfe Bild plötzlich unscharf. Will man die Spannungsfreiheit bei Zimmertemperatur ermitteln, muß man die Membran zunächst abkühlen und dann langsam auf Zimmertemperatur erwärmen.

Mit Hilfe dieser Testmethode läßt sich durch eine einfache Versuchsreihe leicht ermitteln, mit wieviel Arsen oder Germanium die hoch bordotierte Schicht in der Maskenstruktur dotiert werden muß, damit sie bei Zimmertemperatur spannungsfrei ist. Bei einer 2 μm dicken bordotierten Schicht, deren Borkonzentration - wie bereits erwähnt - an der Schichtunterseite $7 \times 10^{19}$ Boratome/cm$^3$ beträgt, ist dazu beispielsweise eine Germaniumkonzentration von etwa $8 \cdot 10^{20}$ Atomen/cm$^3$ erforderlich. Die Gegendotierung wird auf konventionelle Weise mittels Ionenimplantation oder Diffusion durchgeführt. Nachdem die Maskenstruktur auf diese Weise spannungsfrei gemacht worden ist, ist sie noch nicht für den praktischen Einsatz, d.h. für die Bestrahlung mit einem hinreichend hohen Strahlstrom für ein in einer fabrikmäßigen Fertigung erforderlichen Durchsatz ausgerüstet. Bei den Elektronenstrahllithographieverfahren unter Verwendung der erfindungsgemäßen Maske benutzt man für die Maskenbelichtung einen Elektronenstrahl, welcher schnell in Zeilen über die Maske geführt wird. Die dadurch verursachte Aufheizung der dünnen Membran entspricht derjenigen einer Flutbelichtung. Wegen der relativ guten Wärmeableitung über die als Rahmen für die Siliziummembran dienenden ungeätzten Bereiche des Siliziumplättchens stellt sich in der Siliziummembran eine Temperaturverteilung mit einem Maximum in der Membranmitte ein. Die ausgezogene Kurve a in der Fig. 3 zeigt schematisch für einen Querschnitt durch die Maskenmembran das Profil der Temperaturdifferenzen bezogen auf die Temperatur des Membranrandes, das sich über die Siliziummembran einstellt. Würde die im vorangegangenen Verfahrensschritt durch Dotierung spannungsfrei gemachte Siliziummembran einem solchen Strahlstrom ausgesetzt, würde sie sich infolge der sich dabei aufbauenden Druckspannung ausbeulen. Um zu verhindern, daß sich diese Druckspannung aufbaut, wird deshalb im nun folgenden Verfahrensschritt die Siliziummembran abgestimmt auf einen festgelegten Strahlstrom uneinheitlich mit einem Zugspannung erzeugenden Material dotiert. Als Dotierungsmaterial kommen Materialien infrage, welche einen kleineren kovalenten Atomdurchmesser als Silizium haben. Zu diesen Materialien gehören insbesondere Bor aber auch Phosphor und Kohlenstoff. Es besteht ein linearer Zusammenhang zwischen den beim Bestrahlen sich einstellenden Temperaturdifferenzen und den Zugspannungen, welche sie kompensieren können. Andererseits gilt inbesondere in dem Dotierungsbereich von $10^{19}$ bis $10^{20}$ Boratomen/cm$^3$ in Silizium ein nahezu linearer Zusammenhang zwischen der Dotierungskonzentration und der dadurch induzierten örtlichen Zugspannung. Beim Vorliegen einer Temperaturverteilung, wie sie die Fig. 4 wiedergibt, ist es deshalb möglich, durch eine Bordotierung, deren Profil über denselben Querschnitt durch die Membran einen geometrisch ähnlichen Verlauf wie die Temperaturdifferenzen hat, die Maske spannungsfrei zu machen. Diese Verhältnisse veranschaulicht die Kurve b in der Fig. 3. Erzeugen läßt sich eine solche Dotierung insbesondere durch Ionenimplantation, wobei der Borionenstrahl beim zeilenweisen Überstreichen der Siliziummembran in seiner Intensität oder in seiner Geschwindigkeit so computergesteuert wird, daß eine Konzentrationsverteilung des Bors in der Siliziummembran resultiert, die eine Übersetzung des zweidimensionalen Dotierungsprofils, wie es beispielsweise in der Fig. 4 gezeigt ist, ins Dreidimensionale darstellt. Die in den Fig. 3 (s. Kurve b) und 4 gezeigten Dotierungsprofile genügen näherungsweise einer Parabelfunktion. Durch eine einfache Versuchsreihe lassen sich deshalb die Steuerdaten zur Erzeugung der bei einem festgelegten Strahlstrom für die Spannungsfreiheit erforderliche Dotierungsverteilung leicht ermitteln.

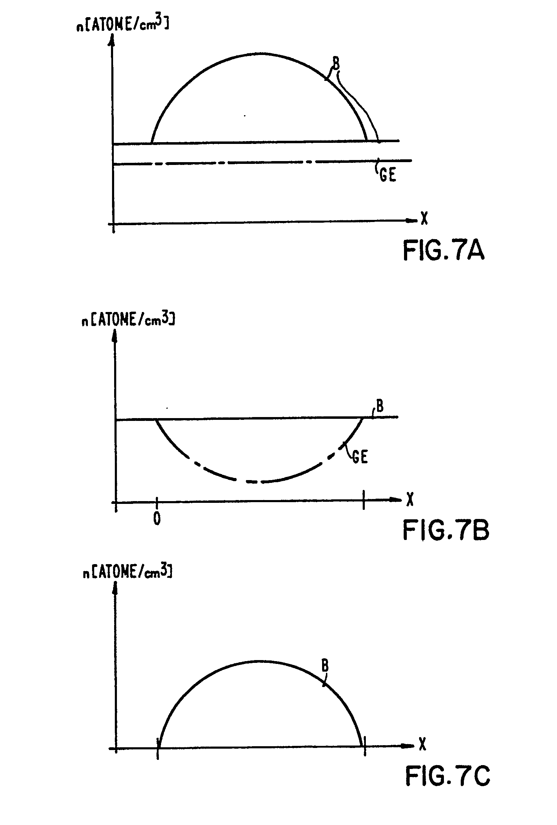

Die Fig. 7a zeigt in schematischer Darstellung über einen Querschnitt durch die Siliziummembran die Dotierungsprofile, die bei den drei während der oben beschriebenen Herstellung der Maske durchgeführten Dotierungen erzeugt werden : Nämlich

    1. die erste, lateral homogene Bordiffusion zur Erzeugung des Ätzstops,

    2. die Germaniumdotierung zur Kompensation der Spannungen bei Raumtemperatur und schließlich

    3. die zweite Bordiffusion zur Erzeugung einer spannungsfreien Maske bei der Bestrahlung der Siliziummembran mit einem festgelegten Strahlstrom (lateral inhomogenes Dotierungsprofil).

Daß die fertige Maske bei dem festgelegten Strahlstrom tatsächlich spannungsfrei ist, wird festgestellt, indem die Maske während der oben beschriebenen mikroskopischen Spannungsmessung mit dem festgelegten Strahlstrom bestrahlt wird.

Bei der uneinheitlichen Dotierung mittels Diffusion wird die Siliziummembran beispielsweise durch Stromdurchfluß oder durch eine entsprechende Wärmestrahlung erhitzt, wobei sich wegen der unterschiedlichen Entfernung zum gut Wärme ableitenden Rahmen starke Temperaturdifferenzen zwischen Membranmitte und Membranrand einstellen, so daß sich, wenn die Siliziummembran der Diffusionsquelle ausgesetzt wird, wegen der aufgrund der Temperaturunterschiede unterschiedlichen Diffusionskoeffizienten die gewünschte uneinheitliche Dotierung einstellt.

Zur Erzeugung der in der Fig. 1 gezeigten Ausgestaltung der erfindungsgemäßen Maske können die Dotierungsschritte auch so durchgeführt werden, daß sich andere Dotierungsprofile als die in der Fig. 7a gezeigten ergeben. So sind die in der Fig. 7b gezeigten Profile so entstanden, daß auf die erste Bordotierung nicht eine zweite Dotierung folgt, welche die Maske bei Zimmertemperatur spannungsfrei macht, sondern daß bei der zweiten Dotierung mit einem Material, welches einen größeren kovalenten Atomdurchmesser als Silizium hat, d.h. z.B. mit Germanium, die Siliziummembran in der Weise uneinheitlich gegendotiert wird, daß das Germanium am Rand der Siliziummembran ein Maximum hat und in der Mitte ein Minimum (es wird also ein inhomogenes Germaniumprofil erzeugt, das zu dem in Fig. 7a gezeigten inhomogenen Borprofil invers ist), wobei die Konzentrationen von Bor und Germanium so aufeinander abgestimmt werden, daß die resultierende Konzentrationsverteilung des nicht kompensierten Bors dieselbe ist, wie wenn man - wie anhand der Fig. 7a veranschaulicht worden ist - drei Dotierungen durchführt. Das in der Fig. 7c gezeigte Dotierungsprofil kann dadurch erzeugt werden, daß zur Erzeugung der Spannungsfreiheit bei Zimmertemperatur nicht gegendotiert wird, sondern die nach der ersten Dotierung vorhandene hohe Bordotierung nach dem Dünnätzen ausdiffundiert wird und dann die uneinheitliche Bordotierung wie oben beschrieben erzeugt wird.

Die Herstellung der in der Fig. 2 gezeigten Ausgestaltung der erfindungsgemäßen Maske unterscheidet sich nur dadurch von der Herstellung der in der Fig. 1 gezeigten Ausgestaltung, daß das Maskenmuster nicht in die hoch bordotierte Schicht eingeätzt wird, sondern in eine auf der Siliziummembran aufliegenden Metallauflage. Diese Alternative des Verfahrens ist bekannt und beispielsweise in dem US-Patent 3 742 230 beschrieben.

## Ansprüche

1. Maske für die Ionen-, Elektronen- oder Röntgenstrahllithographie, die ein Halbleiterplättchen (1) aufweist, dessen eine Oberfläche mindestens bereichsweise bis in eine Tiefe von 2-3 μm anders dotiert ist als das übrige Halbleiterplättchen und das von der anderen Oberfläche aus selektiv bis zu der anders dotierten Schicht unter Bildung einer dünnen Membran (3) weggeätzt ist, und bei der ein das Maskenmuster definierendes Lochmuster (4) entweder in die Membran (3) oder in eine auf der Membran aufliegende Schicht (5) hineingeätzt ist, dadurch gekennzeichnet, daß die Membran (3) eine Zugspannung erzeugende Dotierung aufweist, welche über die Membran uneinheitlich ist, wobei die Konzentration am Rand der Membran (3) minimal und in deren Mitte maximal ist.

2. Maske nach Patentanspruch 1, dadurch gekennzeichnet, daß das Halbleiterplättchen (1) aus Silizium besteht.

3. Maske nach Patentanspruch 2, dadurch gekennzeichnet, daß als die Zugspannung erzeugendes Dotierungsmaterial mindestens ein Element mit einem kleineren kovalenten Atomradius als Silizium, wie z.B. Bor, Kohlenstoff oder Phosphor dient.

4. Maske nach einem oder mehreren der Patentansprüche 1 bis 3, dadurch gekennzeichnet, daß die Konzentrationsverteilung der die Zugspannung erzeugenden Dotierung über die Membran (3) direkt proportional ist der Temperaturverteilung, die sich beim Bestrahlen mit Elektronen- oder Röntgenstrahlung in der Membran (3) einstellt.

5. Maske nach einem der Patentansprüche 1 bis 4, dadurch gekennzeichnet, daß die Wirkung des die Zugspannung erzeugenden mindestens einen Elementes teilweise durch ein Zugspannung abbauendes Dotierungsmaterial kompensiert ist, wobei in Silizium diese Zugspannung abbauenden Elemente, zu denen Germanium gehört, einen größeren kovalenten Atomradius als Silizium haben.

6. Maske nach einem der Patentansprüche 1 bis 5, dadurch gekennzeichnet, daß die Membran (3) 11 × 11 mm² groß und 2 m dick ist, die Gesamtlochfläche 40% der Membranfläche beträgt und, wenn sie einem Strahlstrom von 10 μA ausgesetzt wird, spannungsfrei ist, und die nicht kompensierte Bordotierung in der Mitte der Membran um einen Betrag (in $10^{19}$ Atomen/cm³), der zum anzuwendenden Strahlstrom (in μA) im Verhältnis von etwa 3 : 20 steht, größer ist als an ihrem Rand.

7. Maske nach einem der Ansprüche 1 bis 6, dadurch gekennzeichnet, daß das Profil der Zugspannung erzeugenden Dotierung über die Membran (3) näherungsweise einer Parabelfunktion genügt.

8. Verfahren zum Herstellen einer Maske nach einem der Ansprüche 1 bis 7, bei dem ein Halbleiterplättchen (1) von der einen Oberfläche aus 2-3 μm tief

anders als das übrige Halbleiterplättchen dotiert wird und von der andern Oberfläche aus selektiv bis zu der anders dotierten Schicht unter Erzeugung der Membran (3) weggeätzt wird, und bei dem das das Maskenmuster definierende Lochmuster (4) in die Membran bzw. dort wo die Membran entstehen soll in das Halbleiterplättchen oder in eine auf der Membran aufgebrachte Schicht (5) hineingeätzt wird, dadurch gekennzeichnet, daß die Membran (3) mittels einer weiteren Dotierung oder Ausdiffusion zur Eliminierung von durch die erste Dotierung erzeugten mechanischen Spannungen und/oder einer zusätzlichen uneinheitlichen Dotierung derart behandelt wird, daß die Membran (3) eine der bei der Bestrahlung mit Ionen-, Elektronen- oder Röntgenstrahlen sich über ihr einstellenden Temperaturverteilung proportionale Zugspannung erzeugende Dotierung erhält.

9. Verfahren nach Anspruch 8, dadurch gekennzeichnet, daß ein p- oder n-dotiertes Siliziumplättchen (1) zunächst 2-3 μm tief mit Bor p$^+$-dotiert wird, daß nach der Erzeugung der Membran (3) die Bordotierung durch eine Dotierung mit einem Material aus der Gruppe Germanium, Indium, Arsen und Antimon bis zur Spannungsfreiheit bei Raumtemperatur kompensiert wird und die Membran (3) mit einem Material aus der Gruppe Bor, Kohlenstoff, Phosphor in der Weise uneinheitlich dotiert wird, daß die bei der uneinheitlichen Dotierung entstehende Konzentrationsverteilung über die Membran (3) der bei der Bestrahlung mit Elektronen- oder Röntgenstrahlung sich über ihr einstellenden Temperaturverteilung proportional ist.

10. Verfahren nach Patentanspruch 8, dadurch gekennzeichnet, daß ein p- oder n-dotiertes Siliziumplättchen zunächst 2-3 μm tief mit Bor dotiert wird, und daß zur teilweisen Kompensation der Bordotierung zusätzlich mit einem Material aus der Gruppe Germanium, Indium, Arsen und Antimon in der Weise zusätzlich uneinheitlich dotiert wird, daß das Konzentrationsprofil der zusätzlichen Dotierung über die Membran (3) der inversen Temperaturverteilung über die Membran (3), die sich bei der Bestrahlung mit Ionen-, Elektronen- oder Röntgenstrahlen einstellt, proportional ist, wobei die zusätzliche Dotierung in der Mitte der Membran (3) ein Minimum hat und am Rand ein Maximum.

11. Verfahren nach einem der Ansprüche 8 bis 10, dadurch gekennzeichnet, daß in der Weise zusätzlich dotiert wird, daß bei dem festgelegten Strahlungsstrom die Restspannung in der Membran (3) zwischen Null und der Spannung liegt, welche eine maximale Verzerrung in der Membran (3) von etwa 10 nm verursacht.

12. Verfahren nach einem der Ansprüche 8 bis 11, dadurch gekennzeichnet, daß die zusätzliche uneinheitliche Dotierung mittels Ionenimplantation durchgeführt wird, wobei der Ionenstrahl zeilenweise über die Membran (3) geführt und dabei entweder die Intensität des Strahls oder Geschwindigkeit, mit der er geführt wird, computergesteuert entsprechend dem angestrebten Dotierungsprofil variiert wird.

**Claims**

1. Mask for ion, electron or X-ray lithography, which comprises a semiconductor wafer (1), the doping of one of the wafer surfaces differing at least in regions down to a depth of 2-3 μm from the rest of the wafer, and said wafer being selectively etched off from the other surface down to the differently doped layer, with a thin membrane (3) being formed in the process, and where a hole pattern (4) defining the mask pattern is etched either into the membrane (3) or into a layer (5) deposited on the membrane, characterized in that the membrane (3) has a tensile stress-generating doping which over the membrane is nonuniform, with the concentration being at a minimum in the periphery of the membrane (3) and at a maximum in its center.

2. Mask as claimed in claim 1, characterized in that the semiconductor wafer (1) consists of silicon

3. Mask as claimed in claim 2, characterized in that as a tensile stress-generating doping material at least one element with a smaller covalent atomic radius than silicon, as e.g. boron, carbon or phosphorus is used.

4. Mask as claimed in any one or several of patent claims 1 to 3, characterized in that the concentration distribution of the tensile stress-generating doping over the membrane (3) is directly proportional to the temperature distribution during irradiation with electron, ion or X-ray beams in the membrane (3).

5. Mask as claimed in any one of claims 1 to 4, characterized in that the effect of the at least one tensile stressgenerating element is partly compensated by a doping material eliminating the tensile stress, these tensile stress-eliminating elements, which include germanium, having in silicon a greater covalent atomic radius than silicon.

6. Mask as claimed in any one of claims 1 to 5, characterized in that the membrane (3) is 11 x 11 mm² large and 2 μm thick, that the overall hole surface amounts to 40% of the membrane surface and that it is tension-free if exposed to a beam current of 10 μA, and in that the noncompensated boron doping in the center of the membrane is higher than in its periphery by an amount (in $10^{19}$ atoms/cm³) which is in a ratio of approximately 3 : 20 to the beam current (in μA) to be used.

7. Mask as claimed in any one of claims 1 to 6, characterized in that the profile of the tensile stress-generating doping over the membrane (3) approximately follows a parabolic function.

8. Method of making a mask as claimed in any one of claims 1 to 7, where a semiconductor wafer (1) is doped from the one surface to a depth of 2-3 μm differently from the remaining semiconductor wafer, and where from the other surface said wafer is selectively etched off down to the differently doped layer, with a membrane (3) being formed in the process, and where the pattern of holes (4) defining the mask pattern is etched into the membrane, or into the semiconductor wafer where the membrane is to be formed respectively, or into a layer (5) deposited on the membrane, characterized in that the membrane (3), by means of an additional doping or out-diffusion to eliminate mechanical tensions produced through the first doping, and/or an additional non-uniform doping is processed in such a manner that it receives a doping which generates a tension stress being proportional to the temperature distribution developing thereover in the irradiation with ion, electron or X-rays.

9. Method as claimed in claim 8, characterized in that a p- or n-doped silicon wafer (1) is, first, p$^+$-doped with boron to a depth of 2-3 μm, that following the producing of the membrane (3) the boron doping is compensated by a doping with a material selected from the group consisting of germanium, indium, arsenic and antimony until absence of tension at room temperature, and in that the membrane (3) is non-uniformly doped with a material selected from the group consisting of boron, carbon, phosphorus, in such a manner that the concentration distribution over the membrane (3) developing during the non-uniform doping is proportional to the temperature distribution existing thereover in the irradiation in the electron or X-rays.

10. Method as claimed in claim 8, characterized in that a p- or n-doped silicon wafer is, first, doped with boron to a depth of 2-3 μm, and that for partly compensating the boron doping there follows an additional non-uniform doping with a material selected from the group consisting of germanium, indium, arsenic and antimony, in such a manner that the concentration profile of the additional doping over the membrane (3) is proportional to the inverse temperature distribution over the membrane (3) developing in the irradiation with ion, electron or X-rays, with the additional doping having a minimum in the center of the membrane (3), and a maximum at the periphery.

11. Method as claimed in any one of claims 8 to 10, characterized in that doping is effected in such a manner that for the predetermined beam current the residual tension in the membrane (3) is between zero and that tension which causes a maximum distortion in the membrane (3) of approximately 10 nm.

12. Method as claimed in any one of claims 8 to 11, characterized in that the additional non-uniform doping is implemented by means of ion implantation, with the ion beam scanning the membrane (3), and that either the intensity of the beam or the speed of its motion is varied under computer control in accordance with the desired doping profile.

## Revendications

1. Masque pour la lithographie utilisant un faisceau d'ions, un faisceau d'électrons ou un faisceau de rayons X, qui comporte une plaquette à semiconducteurs (1), dont une surface est dopée, au moins par zones et jusqu'à une profondeur de 2-3 μm, différemment du reste de la plaquette à semiconducteurs et qui est corrodée de façon sélective à partir de l'autre surface jusqu'à une couche dopée différemment, en formant une membrane mince (3), et dans lequel un modèle de trous (4), qui définit le modèle du masque, est ménagé par corrosion soit dans la membrane (3), soit dans une couche (5) située sur la membrane, caractérisé en ce que la membrane (3) possède un dopage qui produit une contrainte de traction et est hétérogène dans cette membrane, la concentration étant minimale au niveau du bord de la membrane (3) et maximale au niveau de son centre.

2. Masque selon la revendication 1, caractérisé en ce que la plaquette à semiconducteurs (1) est constituée par du silicium.

3. Masque selon la revendication 2, caractérisé en ce qu'on utilise comme substance dopante produisant la contrainte de traction au moins un élément possédant un rayon atomique covalent inférieur à celui du silicium, comme par exemple le bore, le carbone ou le phosphore.

4. Masque selon une ou plusieurs des revendications 1 à 3, caractérisé en ce que la distribution de la concentration du dopage produisant la contrainte de traction, dans la membrane (3) est directement proportionnelle à la distribution de température, qui s'établit lors de la pénétration d'un rayonnement électronique ou d'un rayonnement X dans la membrane (3).

5. Masque selon l'une des revendications 1 à 4, caractérisé en ce que l'action d'au moins un élément produisant la contrainte de traction est compensée partiellement par une substance dopante réduisant la contrainte de traction, des éléments, qui réduisent cette contrainte de traction dans le silicium et dont fait partie le germanium, possédant un rayon atomique covalent supérieur à celui du silicium.

6. Masque selon l'une des revendications 1 à 5, caractérisé en ce que la membrane (3) a pour dimensions 11 x 11 mm$^2$ et possède une épaisseur de 2 μm, que la surface totale des trous est égale à 40% de la surface de la membrane et que, lorsque la membrane est soumise à un courant de faisceau de 10 μA, elle n'est le siège d'aucune contrainte et que le dopage au bore non compensé est plus élevé au centre que sur le bord, de la membrane d'une valeur (en 10$^{19}$ atomes/cm$^3$), qui est dans un rapport égal à environ 3 :20 avec le courant de faisceau devant être utilisé (en μA).

7. Masque selon l'une des revendications 1 à 6, caractérisé en ce que le dopage, qui produit le profil de la contrainte de traction, dans la membrane (3) suit approximativement une fonction parabolique.

8. Procédé pour fabriquer un masque suivant l'une des revendications 1 à 7, selon lequel on dope une microplaquette à semiconducteurs (1) 2 à 3 μm plus profondément à partir d'une surface que dans le reste de la microplaquette et qu'on lui applique de façon sélective une corrosion à partir de l'autre surface jusqu'à la couche dopée différemment, en formant la membrane (3), et selon lequel on aménage par corrosion le modèle de trous (4) définissant le modèle du masque dans la membrane ou à un endroit où la membrane doit être formée, dans la microplaquette à semiconducteurs ou dans une couche (5) déposée sur la membrane, caractérisé en ce qu'on traite la membrane (3) en utilisant un autre dopage ou une diffusion pour éliminer des contraintes mécaniques produites par le premier dopage et/ou au moyen d'un dopage hétérogène supplémentaire de manière que la membrane (3) reçoive un dopage produisant une contrainte de traction proportionnelle à la distribution de température s'établissant dans la membrane lors de l'irradiation avec un faisceau d'ions, un faisceau d'électrons ou un faisceau de rayons X.

9. Procédé selon la revendication 8, caractérisé en ce qu'on applique tout d'abord à la plaquette de silicium (1) dopée de type p ou n un dopage de type $p^+$ sur une profondeur de 2-3 μm en utilisant du bore, qu'après la formation de la membrane (3), on compense le dopage au bore par un dopage avec un matériau tiré du groupe germanium, indium, arsenic et antimoine, jusqu'à la suppression des contraintes à la température ambiante, et qu'on dope de façon hétérogène la membrane (3) avec un matériau du groupe bore, carbone, phosphore de manière que la distribution de la concentration, qui apparaît dans la membrane (3) lors du dopage hétérogène, soit proportionnelle à la distribution de température qui s'établit dans la membrane lors de l'irradiation avec un faisceau d'électrons ou un faisceau de rayons X.

10. Procédé selon la revendication 8, caractérisé en ce qu'on dope tout d'abord une plaquette de silicium dopée de type p ou n avec du bore sur une profondeur de 2-3 μm et que pour réaliser une compensation partielle du dopage effectué avec le bore, on réalise en supplément un dopage hétérogène avec un matériau du groupe germanium, indium, arsenic et antimoine de manière que le profil de concentration du dopage supplémentaire dans la membrane (3) soit proportionnel à l'inverse de la distribution de température dans la membrane (3), qui s'établit lors d'une irradiation avec un faisceau d'ions, un faisceau d'électrons et un faisceau de rayons X, le dopage supplémentaire possédant une valeur minimale au centre de la membrane (3) et une valeur maximale sur son bord.

11. Procédé selon l'une des revendications 8 à 10, caractérisé en ce qu'on exécute le dopage supplémentaire de manière que, pour un courant de faisceau fixé, la contrainte résiduelle dans la membrane (3) soit comprise entre une valeur nulle et la contrainte qui provoque une déformation maximale d'environ 10 nm dans la membrane (3).

12. Procédé selon l'une des revendications 8 à 11, caractérisé en ce qu'on exécute le dopage hétérogène supplémentaire au moyen d'une implantation d'ions, le faisceau d'ions étant déplacé ligne-par-ligne sur la membrane (3) et l'intensité du faisceau ou la vitesse avec laquelle il est déplacé étant modifiée d'une manière commandée par ordinateur, en fonction du profil de dopage que l'on recherche.

FIG.1

FIG.2

FIG. 3

FIG. 4

FIG. 5

FIG. 6

n[ATOME/cm³]

FIG.7A

n[ATOME/cm³]

FIG.7B

n[ATOME/cm³]

FIG.7C